(19) Europäisches Patentamt
European Patent Office
Office européen des brevets

(11) **EP 2 225 829 B1**

(12) **EUROPÄISCHE PATENTSCHRIFT**

(45) Veröffentlichungstag und Bekanntmachung des Hinweises auf die Patenterteilung:
**26.09.2012 Patentblatt 2012/39**

(51) Int Cl.:
*H03K 5/003* (2006.01)      *H03F 3/45* (2006.01)
*H03K 5/24* (2006.01)

(21) Anmeldenummer: 08863024.9

(22) Anmeldetag: **11.11.2008**

(86) Internationale Anmeldenummer:
**PCT/EP2008/065286**

(87) Internationale Veröffentlichungsnummer:
**WO 2009/077265 (25.06.2009 Gazette 2009/26)**

(54) **KOMPARATORSCHALTUNG**

COMPARATOR CIRCUIT

CIRCUIT COMPARATEUR

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **19.12.2007 DE 102007061380**

(43) Veröffentlichungstag der Anmeldung:
**08.09.2010 Patentblatt 2010/36**

(73) Patentinhaber: **Robert Bosch GmbH**
**70442 Stuttgart (DE)**

(72) Erfinder:
• **LAND, Christoph**
**72135 Dettenhausen (DE)**
• **JAKOBI, Lothar**
**72574 Bad Urach (DE)**
• **BECKERT, Matthias**
**72764 Reutlingen (DE)**
• **HERMANN, Carsten**
**72762 Reutlingen (DE)**

(56) Entgegenhaltungen:
**US-A- 5 589 785     US-A1- 2005 225 389**

• **CARRILLO J M ET AL: "CONSTANT-GM CONSTANT-SLEW-RATE HIGH-BANDWIDTH LOW-VOLTAGE RAIL-TO-RAIL CMOS INPUT STAGE FOR VLSI CELL LIBRARIES", IEEE JOURNAL OF SOLID-STATE CIRCUITS, IEEE SERVICE CENTER, PISCATAWAY, NJ, US, vol. 38, no. 8, 1 August 2003 (2003-08-01) , pages 1364-1372, XP001170976, ISSN: 0018-9200, DOI: DOI:10.1109/JSSC.2003.814430**

**Beschreibung**

Stand der Technik

Komparatorschaltschwellen von Komparatoren sollten zur Erzielung einer vorgegebenen Genauigkeit langzeitstabil sein. Hierbei ist insbesondere die Verarbeitung von Eingangssignalen problematisch, die an die negative Versorgungsspannung, im Allgemeinen Masse, heranreichen können. Werden diese Eingangssignale auf die Gates eines NMOS-Transistor-Paares gegeben, können in der Regel keine Eingangsspannungen die kleiner als die Einsatzspannung (bzw. Schwellspannung oder threshold voltage) der NMOS-Transistoren von z.B. 0.7V sind, aufgenommen werden, da sonst der N-Kanal abgeschnürt wird. Der Einsatz eines PMOS-Transistor- Eingangspaars ermöglicht auch die Aufnahme niedriger Spannungspegel bis herab zur negativen Versorgungsspannung bzw. Masse. PMOS-Transistoren moderner CMOS-Prozesse weisen jedoch aufgrund des dünnen Gate-Oxids ein Driftverhalten in der Einsatzspannung (threshold voltage) während der Alterung auf. Sind diese Driften bei den Transistoren des Eingangspaars verschieden, kann beim Komparator während seiner Lebensdauer ein Offset entstehen. Unterschiedliche zeitliche Verläufe der Driften entstehen durch unterschiedliche Gate-Source-Spannungen, unterschiedliche Drain-Source-Spannungen oder unterschiedliche Bulk-Source-Spannungen der PMOS-Transistoren des Eingangspaars. Diese Spannungsunterschiede können während des Betriebes auftreten.

Die wissenschaftliche Publikation 'CARRILLO J M ET AL: "Constant-gm Constant-Slew-Rate High-Bandwidth Low-Voltage Rail-to-Rail CMOS Input Stage for VLSI Cell Libraries", IEEE Journal of Solid-State Circuits, Bd. 38, Nr. 8, 1; August 2003, Seiten 1364-1372' offenbart eine Rail-to-Rail Diferenzeingangsstufe umfassend eine potentialverschiebende Schaltung.

Offenbarung der Erfindung

Erfindungsgemäß wird eine Komparatorschaltung gemäß Anspruch 1 geschaffen, die eine potentialverschiebende Schaltung mit einem PMOS-Transistor- Eingangspaar zur Aufnahme der beiden Eingangssignale aufweist, die die beiden Eingangssignale potentialverschoben bzw. Spannungspegel-verschoben als Zwischensignale nachfolgend weitergibt, insbesondere auf ein NMOS- bzw. npn-Transistor-Paar. Die potentialverschiebende Schaltung mit den beiden PMOS- Eingangstransistoren ist vorteilhafterweise durch schaltungstechnische Maßnahmen driftkompensiert.

Der Erfindung liegt der Gedanke zugrunde, durch den Einsatz eines PMOS-Transistor-Paares als Eingangstransistoren auch niedrige Spannungspegel bzw. bis an die negative Versorgungsspannung heran reichende Eingangssignale aufzunehmen und weiterzugeben, wobei vorteilhafterweise durch eine driftkompensierende Einrichtung die bei den PMOS- Eingangstransistoren auftretenden Driften durch schaltungstechnische Maßnahmen gleich gehalten werden, indem die Gate-Source-Spannung, die Drain-Source-Spannung und die Bulk-Source-Spannung beider PMOS- Eingangstransistoren gleich gehalten wird. Vorteilhafterweise werden die Zwischensignale nachfolgend an ein NMOS-Transistor-Eingangspaar (oder auch NPN-Transistor-Eingangpaar) ohne ein derartiges Driftverhalten weitergegeben, das aufgrund der Potentialverschiebung sämtliche von dem PMOS- Eingangstransistor-Paar ausgegebenen, verschobenen Eingangssignale aufnehmen kann, so dass auch niedrige Eingangsignale aufgenommen werden können.

Die beiden PMOS- Eingangstransistoren werden vorteilhafterweise derartig geschaltet, dass die an ihren Anschlüssen anliegenden relevanten Spannungen, d.h. Gate-Source-Spannungen, Drain-Source-Spannungen und Bulk-Source-Spannungen, durch schaltungstechnische Maßnahmen untereinander stets gleich sind und nahezu konstant gehalten werden. Die während der Alterung auftretenden Änderungen der Einsatzspannung (Drift) der beiden PMOS-Eingangstransistoren haben aufgrund der schaltungstechnischen Maßnahmen vorteilhafterweise den gleichen zeitlichen Verlauf, so dass sie als Gleichtaktsignal an dem nachfolgenden Folge-Komparator anliegen und damit aufgrund dessen Gleichtaktunterdrückung wirkungslos bleiben.

Indem der Folge-Komparator ein NMOS-Eingangspaar hat, tritt bei ihm kein relevantes Driftverhalten auf. In der potentialverschiebenden Schaltung sind zusätzlich zu den beiden PMOS-Eingangstransistoren vorteilhafterweise Stromquellen vorgesehen, die mit Stromspiegeln aus PNP- Bipolartransistoren oder mit kaskodierten Stromspiegeln aus PMOS-Transistoren aufgebaut sind. Im letzteren Fall bleibt die Auswirkung der PMOS-Drift in den Stromspiegeln wirkungslos, da die Gate-Source-Spannung, die Drain-Source-Spannung und die Bulk-Source-Spannung der PMOS-Transistoren der Stromspiegel gleich gehalten werden. Die Änderungen der Einsatzspannungen (Drift) dieser Transistoren haben somit den gleichen zeitlichen Verlauf und beeinflussen die Genauigkeit der Stromspiegel und damit der Gesamtschaltung nicht.

Erfindungsgemäß kann somit eine Komparatorschaltung ausgebildet werden, die gegenüber herkömmlichen Komparatoren nur geringe zusätzliche Schaltungsmaßnahmen aufweist und als integrierte Schaltung platzsparend und mit niedrigem Energieverbrauch ausgebildet werden kann. Erfindungsgemäß können Eingangssignale mit Spannungspegeln aufgenommen werden, die nahe an die negative Versorgungsspannung heranreichen, wobei erfindungsgemäß trotz des auftretenden Driftverhaltens der eingesetzten Transistoren kein bzw. keine relevante Beeinträchtigung der Schalteigenschaften (insbesondere des Offsets) der gesamten Komparatorschaltung stattfindet.

Kurze Beschreibung der Zeichnungen

Fig. 1       zeigt ein Schaltbild einer erfindungsgemäßen Komparatorschaltung gemäß einer Ausführungsform;

Fig. 2a      eine Ausführung der Teilschaltungen II und III gemäß einer Ausführungsform in BiCMOS;

Fig. 2b      eine Ausführung der Teilschaltung der Teilschaltung II und III gemäß einer zu Fig. 2a alternativen Ausführungsform in CMOS.

Ausführungsformen der Erfindung

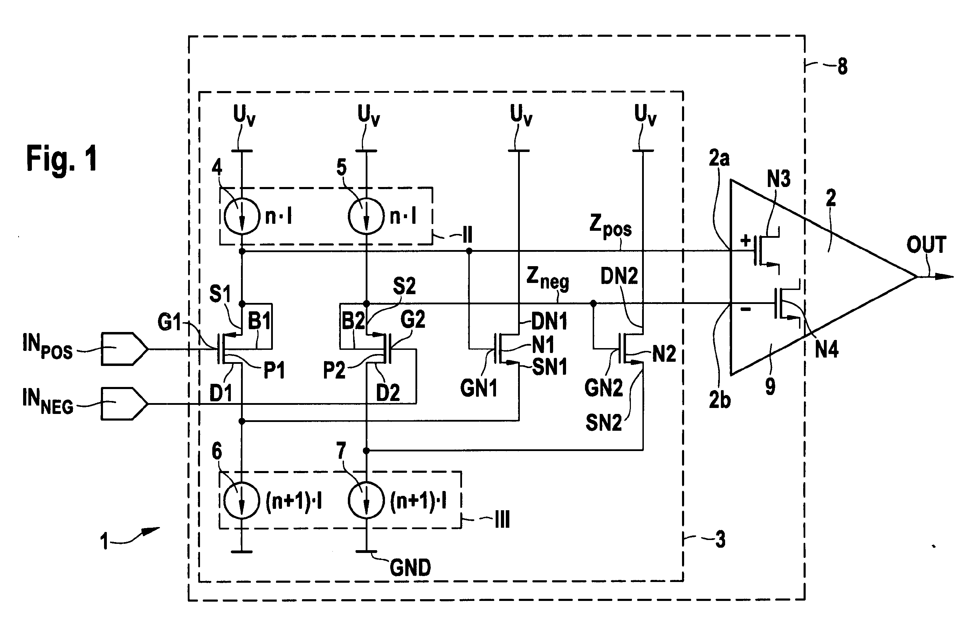

Eine Komparatorschaltung 1 weist gemäß Fig. 1 einen Folge-Komparator 2 mit einem Plus-Eingang 2a und einem Minus-Eingang 2b auf. Der Folge-Komparator 2 ist z.B. in an sich bekannter Weise aufgebaut und weist in seiner im Allgemeinen als Differenzverstärker ausgebildeten Eingangsstufe 9 an seinen beiden Eingängen 2a, 2b einen NMOS-Transistor bzw. n-Kanal MOSFET N3 und einen weiteren NMOS-Transistor N4 auf. Der Ausgang OUT des Folge-Komparators 2 bildet den Ausgang der gesamten Komparatorschaltung 1. Anstelle der NMOS-Transistoren N3 und N4 können auch NPN-Transistoren vorgesehen sein.

Erfindungsgemäß ist vor den Folge-Komparator 2 eine Eingangsschaltung 3 gesetzt. Somit bilden die Eingangsschaltung 3 mit der die MOSFETs N3 und N4 aufweisenden Eingangsstufe 9 des Folge-Komparators 2 eine Eingangsstufenschaltung 8 der gesamten erfindungsgemäßen Komparatorschaltung 1.

Die Eingangsschaltung 3 weist zwei PMOS-Eingangstransistoren P1 und P2 (p-Kanal MOSFETs) auf. An das Gate G1 des ersten PMOS- Eingangstransistors P1 ist der positive Eingang $IN_{POS}$ gelegt. Entsprechend ist an das Gate G2 des zweiten PMOS-Eingangstransistors P2 der negative Eingang $IN_{NEG}$ gelegt. Die Bulkanschlüsse B1 und B2 sind an die jeweiligen Sourceanschlüsse S1 und S2 der PMOS-Eingangstransistoren P1, P2 gelegt. Der Sourceanschluss S1 ist über eine erste Gleichstromquelle 4 an die positive Versorgungsspannung Uv gelegt. Entsprechend ist die Source S2 über eine zweite Gleichstromquelle 5 an die Versorgungsspannung Uv gelegt. Entsprechend ist der Drain-Anschluss D1 des ersten PMOS-Eingangstransistors P1 über eine dritte Gleichstromquelle 6 und der Drain-Anschluss D2 des zweiten PMOS-Transistors P2 über eine vierte Gleichstromquelle 7 auf Masse GND gelegt.

Der Source-Anschluss S1 ist auf den Plus-Eingang 2a des Folge- Komparators 2 gelegt. Entsprechend ist der Source-Anschluss S2 auf den Minus-Eingang 2b des Folge-Komparators 2 gelegt.

Ein NMOS-Transistor N1 ist mit seinem Gate GN1 an den Source-Anschluss S1, mit seinem Drain-Anschluss DN1 an die Versorgungsspannung Uv und mit seinem Source-Anschluss SN1 an den Drain-Anschluss D1 des PMOS-Eingangstransistors P1 gelegt. Entsprechend ist der Gate-Anschluss GN2 eines zweiten NMOS-Transistors N2 an den Source-Anschluss S2 des PMOS-Eingangstransistors P2 gelegt, sein Drain-Anschluss DN2 ist an die Versorgungsspannung Uv und sein Source-Anschluss SN2 an den Drain-Anschluss D2 des PMOS-Eingangstransistors P2 gelegt.

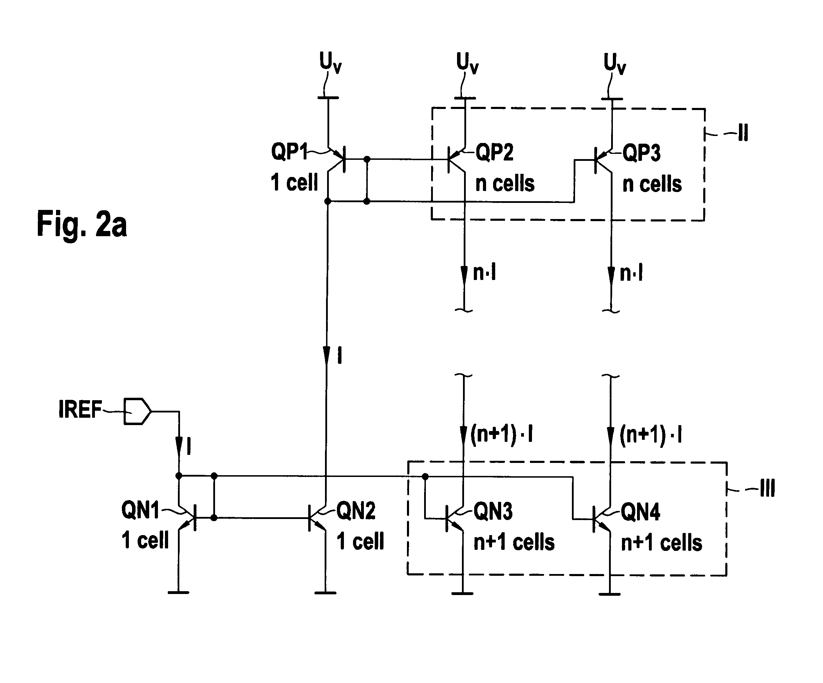

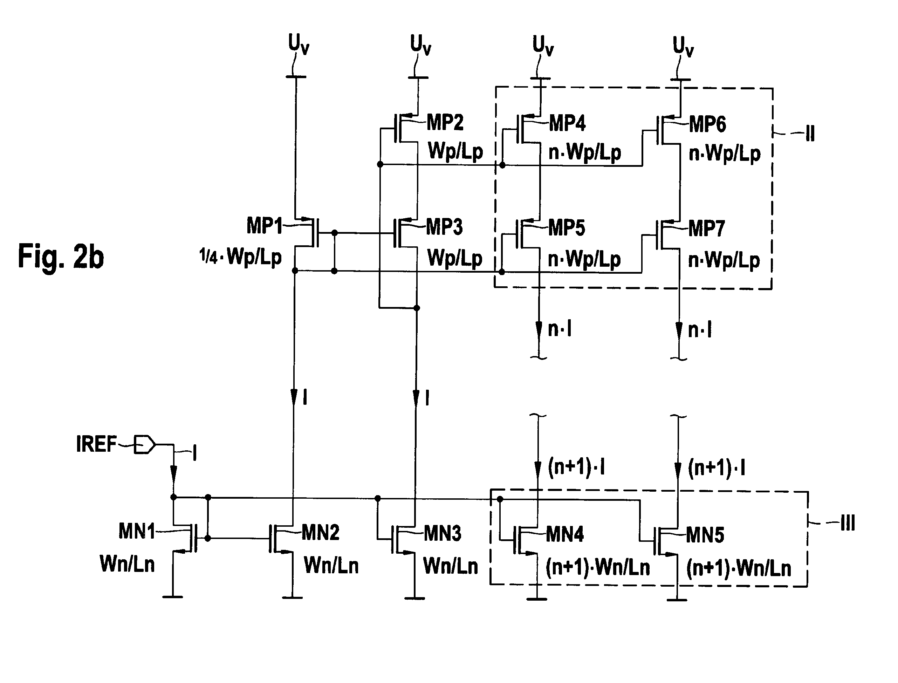

Fig. 2a und Fig. 2b zeigen alternative Ausführungsformen der Teilschaltungen II und III, d.h. der Gleichstromquellen 4 bis 7 aus Fig. 1.

Fig. 2a zeigt beispielhaft mit den NPN-Bipolartransistoren QN1 bis QN4 und den PNP-Bipolartransistoren QP1 bis QP3 zwei einfache Stromspiegel, für den Fall, dass in der verwendeten Technologie Bipolartransistoren zur Verfügung stehen, wie das z. B. in einem BiCMOS-Prozess der Fall ist. Durch den BiCMOS-Prozess können PNP- und NPN-Bipolartransistoren in einem Mischprozess ausgebildet werden. In der Schaltung der Fig. 2a sind QN2 bis QN4 Spiegeltransistoren zu dem Referenztransistor QN1. Die Transistoren QP2 und QP3 sind Spiegeltransistoren zu dem Referenztransistor QP1. Durch den Referenztransistor QN1 fließt der Referenzstrom bzw. Kollektorstrom I = IREF. Aufgrund der gleichen Beschaffenheit von QN1 und QN2 und der gleichen Basis-Emitter-Spannung von QN1 und QN2 fließt auch durch QN2 der Kollektorstrom I. Auch die Basis-Emitter-Spannung von QN3 und QN4 entspricht der von QN1. Die Transistoren QN3 und QN4 bestehen jedoch aus jeweils n+1 Einzelzellen bzw. Einzeltransistoren, wie durch die Angabe "cell, cells" verdeutlicht, so dass durch sie insgesamt jeweils der Strom (n+1)·I fließt. QN3 und QN4 bilden die Gleichstromquellen 6 und 7.

Der Kollektorstrom von QP1 ist gleich dem von QN2, so dass durch den Referenztransistor QP1 der Kollektorstrom I fließt. Die Basis-Emitter-Spannung von QP2 und QP3 entspricht derjenigen von QP1. Die Transistoren QP2 und QP3 bestehen jedoch aus jeweils n Einzelzellen bzw. Einzeltransistoren, so dass durch sie insgesamt jeweils der Strom n·I fließt. QP2 und QP3 bilden die Gleichstromquellen 4 und 5.

Fig. 2b zeigt beispielhaft mit den n-Kanal-MOSFETs MN1 bis MN5 und den p-Kanal-MOSFETs MP1 bis MP7 zwei Stromspiegel für den Fall, dass in der verwendeten Technologie keine Bipolartransistoren zur Verfügung stehen, wie das z.B. in einem reinen CMOS-Prozeß der Fall ist. Die PMOS- Stromspiegel sind in bekannter Form kaskodiert ausgeführt. In der Schaltung der Fig. 2b sind MN2 bis MN5 Spiegeltransistoren zu dem Referenztransistor MN1. Die Transistoren MP4 und MP6 sind Spiegeltransistoren zu dem Referenztransistor MP2. Der Transistor MP1 stellt eine Referenzspannung für die Kaskodetransistoren MP3, MP5 und MP7 zur Verfügung. Wp und Wn beschreiben hierbei die Kanalbreite, Lp und Ln die Kanallänge, sodass Wp/Lp und Wn/Ln die entsprechenden Verhältnisse wiedergeben, die als Kenngrößen der Transistoren hier relevant sind.

Durch den Referenztransistor MN1 fließt der Referenzstrom bzw. Drainstrom I = IREF. Aufgrund der gleichen Beschaffenheit von MN1, MN2 und MN3 und dergleichen Gate-Source-Spannung von MN1, MN2 und MN3 fließt auch durch MN2 bzw. MN3 der Drainstrom I. Auch die Gate-Source-Spannung von MN4 und MN5 entspricht der von MN1. Die Weite der Transistoren MN4 und MN5 ist jedoch jeweils um den Faktor n+1 größer, so dass durch sie insgesamt jeweils der Strom (n+1)·I fließt. MN4 und MN5 bilden die Gleichstromquellen 6 und 7.

Der Drainstrom von MP2 ist gleich dem von MN3, so dass durch den Referenztransistor MP2 der Drainstrom I fließt. Die Gate-Source-Spannung von MP4 und MP6 entspricht der der von MP2. Die Weite der Transistoren MP4 und MP6 ist jedoch jeweils um den Faktor n größer, so dass durch sie insgesamt jeweils der Strom n·I fließt. MP4 und MP6 bilden die Gleichstromquellen 4 und 5. Damit die Auswirkung der PMOS-Drift ohne Wirkung auf das Verhalten des PMOS-Stromspiegels bleibt, werden die Drain-Source-Spannungen von MP2, MP4 und MP4 gleich gehalten werden. Hierzu dienen die Kaskodetransistoren MP3, MP5 und MP7, deren Gate-Potential von dem Transistor MP1 gebildet wird, indem durch ihn der gleiche Drainstrom fließt, der auch durch MN2 fließt. Gegenüber MP2 hat MP1 jedoch eine um den Faktor 1/4 kleinere Weite, so dass seine Gate-Source-Spannung etwa 200mV größer ist als die der Kaskodetransistoren MP3, MP5 und MP7. Das stellt sicher, dass die Spiegeltransistoren stets in Sättigung arbeiten.

Die Schaltung, bestehend aus MN1 bis MN5 und MP1 bis MP7, ist grundsätzlich bekannt. Relevant ist, dass die PMOS-Drift keinen Einfluß auf deren Stromspiegelverhalten haben kann, da der Referenztransistor MP2 und die Spiegeltransistoren MP4 und MP6 stets die gleiche Gate-Source-Spannung, die gleiche Drain-Source-Spannung und die gleiche Bulk-Source-Spannung aufweisen. Somit sind auch die Ströme, die durch die Transistoren P1 und P2, bzw. N1 und N2 der Eingangsschaltung 3 der Fig. 1 fließen, untereinander stets gleich.

Die PMOS- Eingangstransistoren P1 und P2 können Eingangssignale In$_{POS}$ und In$_{NEG}$ verarbeiten, die an die negative Versorgungsspannung GND heranreichen können. Durch die beiden NMOS-Transistoren N1 und N2 sowie die zusätzlichen Stromquellen 4, 5, 6, 7 werden schaltungstechnische Maßnahmen getroffen, durch die die PMOS-Drift keinen Einfluss auf die gesamte Komparatorschaltung 1 hat. Die Gate-Source-Spannungen $U_{GS1}$ und $U_{GS2}$ sind hierdurch stets gleich und werden konstant gehalten. Entsprechend werden auch die Drain-Source-Spannungen $U_{OS1}$ und $U_{DS2}$ stets gleich und im Wesentlichen konstant gehalten, und es werden auch die Bulk-Source-Spannungen $U_{BS1}$ und $U_{BS2}$ gleich und im Wesentlichen konstant gehalten, d.h.

$$U_{GS1} = U_{GS2} \approx \text{konstant}, \; U_{DS1} = U_{DS2} \approx \text{konstant}, \; U_{BS1} = U_{BS2} \approx \text{konstant},$$

so dass P1 und P2 als driftkompensierte Level-Shifter bzw. Spannungspegelverschiebende (potentialverschiebende) Mittel für den nachfolgenden Folge-Komparator 2 dienen.

Die Gate-Source-Spannungen UGS1 und UGS2 der PMOS- Eingangstransistoren P1 und P2 sind gleich, weil durch sie jeweils der gleiche Strom n·I hindurchfließt und weil ihre Drain-Source-Spannungen UDS1 und UDS2 gleich sind. Die Drain-Source-Spannungen der PMOS-Eingangstransistoren P1 und P2 sind gleich, weil sie durch die Gate-Source-Spannungen UGSN1 und UGSN2 von den beiden NMOS-Transistoren N1 und N2 vorgegeben werden, die ebenfalls von gleichen Strömen I durchflossen werden, und die deshalb die gleiche Gate-Source-Spannung UGSN1 und UGSN2 aufweisen. Die Bulk-Source-Spannungen UBS1 und UBS2 der PMOS- Eingangstransistoren P1 und P2 sind gleich (und gleich Null), weil jeweils der Source-Anschluss S1 bzw. S2 eines jeden PMOS-Transistors mit seinem BulkAnschluss B1 bzw. B2 verbunden ist.

An den baugleichen PMOS-Eingangstransistoren P1 und P2 fällt jeweils die gleiche aussteuernde Gate-Source-Spannung $U_{GS1} = U_{GS2}$ ab, so dass die PMOS-Eingangstransistoren P1 und P2 Zwischensignale Zpos und Zneg ausgeben, für die etwa gilt: Zpos - INPOS = Zneg - IN$_{NEG}$ = $U_{GS1}$ = $U_{GS2}$.

N1 und N2 dienen dazu, die Drain-Source-Spannungen $U_{DS1}$ und $U_{DS2}$ der PMOS-Eingangstransistoren P1 und P2 aufzuspannen bzw. durch ihre Gate-Source-Spannungen $U_{GSN1}$ und $U_{GSN2}$ festzulegen; somit dienen N1 und N2 erfindungsgemäß als spannungseinstellende Einrichtungen.

Dies wird aus dem nachfolgenden Beispiel ersichtlich, bei dem die Einsatzspannung der PMOS-Transistoren P1 und P2 UTh1 = UTh2 = 0,5V und die der NMOS-Transistoren N1 und N2 UThn1 = UThn2 = 0,5V sei. Die effektive Gate-Source-Spannung (bzw. gate source overdrive voltage) von P1 und P2 sei durch entsprechende Dimensionierung von Länge und Weite UGS.eff = 0,4V, woraus sich insgesamt eine Gate-Source-Spannung für P1 und P2 von UGS1 = UTh1 + UGS1.eff = 0,9V bzw. UGS2 = UTh2 + UGS2.eff = 0,9V ergibt. Die effektive Gate-Source-Spannung (bzw. gate source overdrive voltage) von N1 und N2 sei durch entsprechende Dimensionierung von Länge und Weite UGSN.eff = 0,2V, woraus sich insgesamt eine Gate-Source-Spannung für N1 und N2 von UGSN1 = UThn1 + UGSN1.eff = 0,7V bzw. UGSN2 = UThn2 + UGSN2.eff = 0,7V ergibt. Falls z.B. $IN_{POS}$=1V und $IN_{NEG}$ = 0V, so stellen sich aufgrund der Gate-Source-Spannungen UGS1 = UGS2 = 0,9V Potentiale US1 = UGN1 = Zpos = 1,9V und US2 = UGN2 = Zneg = 0,9V ein. An den NMOS-Transistoren N1 und N2 fällt jeweils $U_{GSN1} = U_{GSN2}$ = 0,7V ab, wobei die Gate-Source-Spannung der NMOS- Transistoren N1 und N2 geringer als die der PMOS-Transistoren sein muss, damit die Stromquellen 6 und 7 nicht abgeschnürt werden. Da die Source-Anschlüsse SN1 und SN2 an den Drain-Anschlüssen D1 und D2 liegen, wird somit die Drain-Source-Spannung der PMOS- Eingangstransistoren P1 und P2 festgelegt. Durch N1 und N2 fließt weiterhin ein zusätzlicher Strom I, so dass durch die Gleichstromquellen 6 und 7 der Gesamtstrom (n+1)I bzw. etwa (n+1)I' fließt. Der Faktor n kann z.B. auf n=4 festgelegt werden.

Die Einsatzspannung in der PMOS-Eingangstransistoren P1 und P2 verändert sich während der Lebensdauer der gesamten integrierten Komparatorschaltung 1 gleichermaßen, da die Gate-Source-Spannungen, Drain-Source-Spannungen und Bulk-Source-Spannungen untereinander gleich sind und konstant gehalten werden. Die unvermeidbaren Änderungen der Einsatzspannungen $U_{Th1}$ und $U_{Th2}$ von P1 und P2 rufen eine Verschiebung der Pegel an den Eingängen 2a, 2b des Folge-Komparators 2 hervor. Aufgrund der erfindungsgemäßen schaltungstechnischen Maßnahmen haben $U_{Th1}$ und $U_{Th2}$ den gleichen zeitlichen Verlauf:

$$U_{Th1}(t) = U_{Th2}(t)$$

Die Änderung $\Delta U_{Th1} = \Delta U_{Th2}$ liegen als Gleichtaktsignal am Folge- Komparator 2 an und bleiben somit aufgrund der Gleichtaktunterdrückung wirkungslos.

NMOS-Transistoren oder auch NPN-Transistoren weisen ein nicht relevantes Driftverhalten auf. Das NMOS-Transistor-Eingangspaar (bestehend aus N3 und N4) oder ein entsprechendes NPN-Transistor-Paar des Folge- Komparators 2 verursacht während der Lebensdauer daher keinen relevanten Offset.

Vorteilhafterweise sind in dem Folge-Komparator 2 PMOS-Stromspiegel und PMOS-Stromquellen mit Kaskodetransistoren entsprechend Fig. 2a bzw. Fig. 2b vorgesehen.

Die gesamte Komparatorschaltung 1 ist vorteilhafterweise als integrierter Schaltkreis ausgebildet.

**Patentansprüche**

1. Komparatorschaltung zur Aufnahme von zwei Eingangssignalen ($IN_{POS}$, $IN_{NEG}$) und Ausgabe eines Ausgangssignals (OUT),
   wobei die Komparatorschaltung (1) mindestens aufweist:

   eine potentialverschiebende Schaltung (3), die einen ersten PMOS-Eingangstransistor (P1) zur Aufnahme des ersten Eingangssignals ($IN_{POS}$) und einen zweiten PMOS- Eingangstransistor (P2) zur Aufnahme des zweiten Eingangssignals ($IN_{NEC}$) aufweist,
   wobei der erste und der zweite Eingangstransistor deart geschaltet sind, dass

   - die Gate-Source-Spannung und
   - die Drain-Source-Spannungen

   am ersten und zweiten Eingangstransistor (P1, P2) der potentialverschiebenden Schaltung (3) gleich und im Wesentlichen konstant gehalten werden, wodurch sich eine Driftkompensation der potentialverschiebenden Schaltung (3) ergibt,
   wobei die potentialverschiebende Schaltung (3) das erste Eingangssignal und das zweite Eingangssignal um einen im wesentlichen gleichen Spannungswert verschiebt und hierdurch ein erstes Zwischensignal (Zpos) und ein zweites Zwischensignal (Zneg) erzeugt und ausgibt, und
   eine Eingangsstufe (9), die zwei die beiden Zwischensignale (Zpos, Zneg) aufnehmende NMOS- Transistoren (N3, N4) oder npn-Transistoren aufweist.

2. Komparatorschaltung nach Anspruch 1, **dadurch gekennzeichnet, dass** die Bulk-Source-Spannungen am ersten und zweiten Eingangstransistor (P1, P2) gleich und im Wesentlichen konstant gehalten werden.

3.  Komparatorschaltung nach einem der Ansprüche 1 oder 2, **dadurch gekennzeichnet, dass** die Eingangsstufe (9) einen Differenzverstärker (9) mit den beiden NMOS-Transistoren (N3, N4) oder npn-Transistoren aufweist.

4.  Komparatorschaltung nach einem der vorherigen Ansprüche, **dadurch gekennzeichnet, dass** in der potentialverschiebenden Schaltung (3) der Gate-Anschluss (G1) des ersten PMOS- Eingangstransistors (P1) das erste Eingangssignal ($IN_{POS}$) aufnimmt,
der Source-Anschluss (S1) des ersten PMOS- Eingangstransistors (P1) über eine erste Gleichstromquelle (4) an einen ersten Versorgungsspannung (Uv) angeschlossen ist,
der Drain-Anschluss (D1) des ersten PMOS- Eingangstransistors (P1) über eine dritte Gleichstromquelle (6) an den anderen Versorgungsspannungs-Anschluss (GND) angeschlossen ist,
der Gateanschluss (G2) des zweiten PMOS- Eingangstransistors (P2) das zweite Eingangssignal ($IN_{NEG}$) aufnimmt, und
der Source-Anschluss (S2) des zweiten PMOS- Eingangstransistors (P2) über eine zweite Gleichstromquelle (5) an den ersten Versorgungsspannungs -Anschluss (Uv) und der Drain-Anschluss (D2) des zweiten PMOS- Eingangstransistors (P2) über eine vierte Gleichstromquelle (7) an den anderen Versorgungsspannungsanschluss (GND) angeschlossen ist.

5.  Komparatorschaltung nach Anspruch 4, **dadurch gekennzeichnet, dass** bei beiden PMOS- Eingangstransistoren (P1, P2) jeweils der Bulkanschluss (B1, B2) an den Source-Anschluss (S1, S2) gelegt ist.

6.  Komparatorschaltung nach Anspruch 4 oder 5, **dadurch gekennzeichnet, dass** zwischen den Source-Anschluss (S1) und den Drain-Anschluss (D1) des ersten PMOS- Eingangstransistors (P1) eine erste spannungseinstellende Einrichtung (N1) und zwischen den Source-Anschluss (S2) und den Drain-Anschluss (D2) des zweiten PMOS-Eingangstransistors (P2) eine zweite spannungseinstellende Einrichtung (N2) geschaltet ist.

7.  Komparatorschaltung nach Anspruch 6, **dadurch gekennzeichnet, dass** die erste spannungseinstellende Einrichtung ein erster NMOS-Transistor (N1) und die zweite spannungseinstellende Einrichtung ein zweiter NMOS-Transistor (N2) ist,
wobei der erste NMOS-Transistor (N1) mit seinem Gate-Anschluss (GN1) an den Source-Anschluss (S1) des ersten PMOS- Eingangstransistors (P1) und mit seinem Source-Anschluss (SN1) an den Drain-Anschluss (D1) des ersten PMOS-Eingangstransistors (P1, P2) gelegt ist,
wobei der zweite NMOS-Transistor (N2) mit seinem Gate (GN2) an den Source-Anschluss (S2) des zweiten PMOS-Eingangstransistors (P2) und mit seinem Source-Anschluss (SN2) an den Drain-Anschluss (D2) des zweiten PMOS-Eingangstransistors (P2) gelegt ist, und
wobei die Drain-Anschlüsse (DN1, DN2) des ersten und zweiten NMOS-Transistors (N1, N2) an den ersten Versorgungsspannungsanschluss (Uv) gelegt sind.

8.  Komparatorschaltung nach einem der Ansprüche 4 bis 7, **dadurch gekennzeichnet, dass** ein erster Stromspiegel (QP1, QP2, QP3; (MP1, MP2, MP3, MP4, MP5, MP6, MP7) zur Ausbildung der ersten und zweiten Gleichstromquelle (4, 5) zwischen den Source-Anschlüssen (S1, S2) des ersten und zweiten PMOS- Eingangstransistors (P1, P2) und dem ersten Versorgungsspannungsanschluss (Uv) ausgebildet ist.

9.  Komparatorschaltung nach einem der Ansprüche 4 bis 8, **dadurch gekennzeichnet, dass** ein zweiter Stromspiegel (QN1, QN2, QN3, QN4; MN1, MN2, MN3, MN4, MN5) zur Ausbildung der dritten und vierten Gleichstromquelle (6, 7) zwischen den Drain-Anschlüssen (D1, D2) des ersten und zweiten PMOS- Eingangstransistors (P1, P2) und dem zweiten Versorgungsspannungsanschluss (GND) ausgebildet ist.

10. Komparatorschaltung nach Anspruch 9, **dadurch gekennzeichnet, dass** der erste Stromspiegel (MP1, MP2, MP3, MP4, MP5, MP6, MP7) kaskodiert ist.

11. Komparatorschaltung nach einem der Ansprüche 8 bis 10, **dadurch gekennzeichnet, dass** die Stromspiegel jeweils einen Referenztransistor (QP1, QN1, MP1, MN1) und mindestens zwei Parallelschaltungen von mehreren (n, n+1) Transistoren (QP2, QP3; QN3, QN4; MP4, MP5, MP6, MP7; MN4, MN5) und/oder mehreren (n, n+1) Zellen mit jeweils mindestens einem Transistor (QP2, QP3; QN3, QN4; MP4, MP5, MP6, MP7; MN4, MN5) zur Ausbildung der Stromquellen aufweisen.

12. Komparatorschaltung nach Anspruch 11, **dadurch gekennzeichnet, dass** die dritte und vierte Stromquelle (6, 7) mehr Transistoren oder mehr Zellen als die erste und zweite Stromquelle (4, 5) aufweist zur Aufnahme des zusätzlich durch die spannungseinstellenden Einrichtungen (N1, N2) fließenden Stroms.

13. Komparatorschaltung nach einem der Ansprüche 8 bis 12, **dadurch gekennzeichnet, dass** der erste Stromspiegel zur Ausbildung der ersten und zweiten Stromquelle (4, 5) aus pnp-Transistoren (QP1, QP2, QP3) und der zweite Stromspiegel zur Ausbildung der dritten und vierten Stromquelle (6, 7) aus npn-Transistoren (QN1, QN2, QN3, QN4) gebildet ist.

14. Komparatorschaltung nach einem der Ansprüche 8 bis 12, **dadurch gekennzeichnet, dass** der erste Stromspiegel zur Ausbildung der ersten und zweiten Stromquelle (4, 5) aus PMOS-Transistoren (MP1, MP2, MP3, MP4, MP5, MP6, MP7) und der zweite Stromspiegel zur Ausbildung der dritten und vierten Stromquelle (6, 7) aus NMOS-Transistoren (MN1, MN2, MN3, MN4, MN5) gebildet ist.

15. Komparatorschaltung nach einem der vorherigen Ansprüche, **dadurch gekennzeichnet, dass** die eine Eingangsstufe (9) Teil eines Folge-Komparators (2) ist, der die beiden Zwischensignale (Zpos, Zneg) aufnimmt und das Ausgangssignal (OUT) ausgibt.

**Claims**

1. Comparator circuit for taking up two input signals ($IN_{POS}$, $IN_{NEG}$) and outputting an output signal (OUT), wherein the comparator circuit (1) at least comprises:

   a potential-shifting circuit (3), which comprises a first PMOS input transistor (P1) for taking up the first input signal ($IN_{POS}$) and a second PMOS input transistor (P2) for taking up the second input signal ($N_{NEG}$), wherein the first and second input transistors are connected in such a way that

   - the gate-source voltage and
   - the drain-source voltages

   at the first and second input transistors (P1, P2) of the potential-shifting circuit (3) are kept identical and substantially constant, thus resulting in a drift compensation of the potential-shifting circuit (3), wherein the potential-shifting circuit (3) shifts the first input signal and the second input signal by a substantially identical voltage value and thereby generates and outputs a first intermediate signal (Zpos) and a second intermediate signal (Zneg), and an input stage (9), which comprises two NMOS transistors (N3, N4) or npn transistors, which take up the two intermediate signals (Zpos, Zneg).

2. Comparator circuit according to Claim 1, **characterized in that** the bulk-source voltages at the first and second input transistors (P1, P2) are kept identical and substantially constant.

3. Comparator circuit according to either of Claims 1 and 2, **characterized in that** the input stage (9) comprises a differential amplifier (9) having the two NMOS transistors (N3, N4) or npn transistors.

4. Comparator circuit according to any of the preceding claims, **characterized in that** in the potential-shifting circuit (3) the gate terminal (G1) of the first PMOS input transistor (P1) takes up the first input signal ($IN_{POS}$), the source terminal (S1) of the first PMOS input transistor (P1) is connected to a first supply voltage (Uv) via a first DC source (4) the drain terminal (D1) of the first PMOS input transistor (P1) is connected to the other supply voltage terminal (GND) via a third DC current source (6), the gate terminal (G2) of the second PMOS input transistor (P2) takes up the second input signal ($IN_{NEG}$), and the source terminal (S2) of the second PMOS input transistor (P2) is connected to the first supply voltage terminal (Uv) via a second DC current source (5) and the drain terminal (D2) of the second PMOS input transistor (P2) is connected to the other supply voltage terminal (GND) via a fourth DC current source (7).

5. Comparator circuit according to Claim 4, **characterized in that**, in both PMOS input transistors (P1, P2), the respective bulk terminal (B1, B2) is connected to the source terminal (S1, S2).

6. Comparator circuit according to Claim 4 or 5, **characterized in that** a first voltage-setting device (N1) is connected between the source terminal (S1) and the drain terminal (D1) of the first PMOS input transistor (P1) and a second voltage-setting device (N2) is connected between the source terminal (S2) and the drain terminal (D2) of the second PMOS input transistor (P2).

7. Comparator circuit according to Claim 6, **characterized in that** the first voltage-setting device is a first NMOS transistor (N1) and the second voltage-setting device is a second NMOS transistor (N2),
wherein the first NMOS transistor (N1) is connected by its gate terminal (GN1) to the source terminal (S1) of the first PMOS input transistor (P1) and by its source terminal (SN1) to the drain terminal (D1) of the first PMOS input transistor (P1, P2),
wherein the second NMOS transistor (N2) is connected by its gate (GN2) to the source terminal (S2) of the second PMOS input transistor (P2) and by its source terminal (SN2) to the drain terminal (D2) of the second PMOS input transistor (P2), and wherein the drain terminals (DN1, DN2) of the first and the second NMOS transistors (N1, N2) are connected to the first supply voltage terminal (Uv).

8. Comparator circuit according to any of Claims 4 to 7, **characterized in that** a first current mirror (QP1, QP2, QP3; MP1, MP2, MP3, MP4, MP5, MP6, MP7) for forming the first and second DC current sources (4, 5) is formed between the source terminals (S1, S2) of the first and second PMOS input transistors (P1, P2) and the first supply voltage terminal (Uv).

9. Comparator circuit according to any of Claims 4 to 8, **characterized in that** a second current mirror (QN1, QN2, QN3, QN4; MN1, MN2, MN3, MN4, MN5) for forming the third and fourth DC current sources (6, 7) is formed between the drain terminals (D1, D2) of the first and second PMOS input transistors (P1, P2) and the second supply voltage terminal (GND).

10. Comparator circuit according to Claim 9, **characterized in that** the first current mirror (MP1, MP2, MP3, MP4, MP5, MP6, MP7) is cascaded.

11. Comparator circuit according to any of Claims 8 to 10, **characterized in that** the current mirrors each comprise a reference transistor (QP1, QN1, MP1, MN1) and at least two parallel circuits formed by a plurality (n, n+1) of transistors (QP2, QP3, QN3, QN4; MP4, MP5, MP6, MP7; MN4, MN5) and/or a plurality (n, n+1) of cells each having at least one transistor (QP2, QP3; QN3, QN4; MP4, MP5, MP6, MP7; MN4, MN5) for forming the current sources.

12. Comparator circuit according to Claim 11, **characterized in that** the third and fourth current sources (6, 7) have more transistors or more cells than the first and second current sources (4, 5), for taking up the current additionally flowing through the voltage-setting devices (N1, N2).

13. Comparator circuit according to any of Claims 8 to 12, **characterized in that** the first current mirror for forming the first and second current sources (4, 5) is formed from pnp transistors (QP1, QP2, QP3) and the second current mirror for forming the third and fourth current sources (6, 7) is formed from npn transistors (QN1, QN2, QN3, QN4).

14. Comparator circuit according to any of Claims 8 to 12, **characterized in that** the first current mirror for forming the first and second current sources (4, 5) is formed from PMOS transistors (MP1, MP2, MP3, MP4, MP5, MP6, MP7) and the second current mirror for forming the third and fourth current sources (6, 7) is formed from NMOS transistors (MN1, MN2, MN3, MN4, MN5).

15. Comparator circuit according to any of the preceding claims, **characterized in that** the one input stage (9) is part of a sequential comparator (2) which takes up the two intermediate signals (Zpos, Zneg) and outputs the output signal (OUT).

**Revendications**

1. Circuit comparateur destiné à recevoir deux signaux d'entrée ($IN_{POS}$, $IN_{NEG}$) et à délivrer un signal de sortie (OUT), le circuit comparateur (1) présentant au moins :

un circuit (3) de déplacement de potentiel qui présente un premier transistor d'entrée PMOS (P1) qui reçoit le premier signal d'entrée ($IN_{POS}$) et un deuxième transistor d'entrée PMOS (P2) qui reçoit le deuxième signal d'entrée ($IN_{NEG}$),
le premier et le deuxième transistor d'entrée étant raccordés de telle sorte que

la tension grille-source et

les tensions source-drain

du premier et du deuxième transistor d'entrée (P1, P2) du circuit (3) de déplacement de potentiel soient identiques et essentiellement constantes de manière à obtenir une compensation de la dérive du circuit (3) de déplacement de potentiel,

le circuit (3) de déplacement de potentiel déplaçant le premier signal d'entrée et le deuxième signal d'entrée d'une valeur de tension essentiellement identique en formant ainsi un premier signal intermédiaire (Zpos) et un deuxième signal intermédiaire (Zneg) et

un étage d'entrée (9) qui présente deux transistors NMOS (N3, N4) ou deux transistors npn qui reçoivent les deux signaux intermédiaires (Zpos, Zneg).

2. Circuit comparateur selon la revendication 1, **caractérisé en ce que** les tensions masse-source du premier et du deuxième transistor d'entrée (P1, P2) sont identiques et maintenues essentiellement constantes.

3. Circuit comparateur selon l'une des revendications 1 ou 2, **caractérisé en ce que** l'étage d'entrée (9) présente un amplificateur différentiel (9) doté des deux transistors NMOS (N3, N4) ou de deux transistors npn.

4. Circuit comparateur selon l'une des revendications précédentes, **caractérisé en ce que** la borne de grille (G1) du premier transistor d'entrée PMOS (P1) du circuit (3) de déplacement de potentiel reçoit le premier signal d'entrée (IN$_{POS}$).

    **en ce que** la borne de source (S1) du premier transistor d'entrée PMOS (P1) est raccordée à une première tension d'alimentation (Uv) par l'intermédiaire d'une première source (4) de courant continu,

    **en ce que** la borne de drain (D1) du premier transistor d'entrée PMOS (P1) est raccordée à l'autre borne d'alimentation de tension (GND) par l'intermédiaire d'une troisième source (6) de courant continu,

    **en ce que** la borne de grille (G2) du deuxième transistor d'entrée PMOS (P2) reçoit le deuxième signal d'entrée (IN$_{NEG}$) et

    **en ce que** la borne de source (S2) du deuxième transistor d'entrée PMOS (P2) est raccordée à la première borne de tension d'alimentation (Uv) par l'intermédiaire d'une deuxième source (5) de courant continu et la borne de drain (D2) du deuxième transistor d'entrée PMOS (P2) est raccordée à l'autre borne (GND) de tension d'alimentation par l'intermédiaire d'une quatrième source (7) de courant continu.

5. Circuit comparateur selon la revendication 4, **caractérisé en ce que** la borne de masse (B1, B2) est raccordée à la borne de source (S1, S2) des deux transistors d'entrée PMOS (P1, P2).

6. Circuit comparateur selon les revendications 4 ou 5, **caractérisé en ce qu'**un premier dispositif (N1) d'établissement de tension est raccordé entre la borne de source (S1) et la borne de drain (D1) du premier transistor d'entrée PMOS (P1) et **en ce qu'**un deuxième dispositif (N2) d'établissement de tension est raccordé entre la borne de source (52) et la borne de drain (D2) du deuxième transistor d'entrée PMOS (P2).

7. Circuit comparateur selon la revendication 6, **caractérisé en ce que** le premier dispositif d'établissement de tension est un premier transistor NMOS (N1) et le deuxième dispositif d'établissement de tension un deuxième transistor NMOS (N2),

    le premier transistor NMOS (N1) étant raccordé à la borne de source (S1) du premier transistor d'entrée PMOS (P1) par sa borne de grille (GN1) et à la borne de drain (D1) du premier transistor d'entrée PMOS (P1, P2) par sa borne de source (SN1),

    le deuxième transistor NMOS (N2) étant raccordé à la borne de source (S2) du deuxième transistor d'entrée PMOS (P2) par sa grille (GN2) et à la borne de drain (D2) du deuxième transistor d'entrée PMOS (P2) par sa borne de source (SN2) et

    **en ce que** les bornes de drain (DN1, DN2) du premier et du deuxième transistor NMOS (N1, N2) sont raccordées à la première borne (Uv) de tension d'alimentation.

8. Circuit comparateur selon l'une des revendications 4 à 7, **caractérisé en ce qu'**un premier miroir de courant (QP1, QP2, QP3 ; (MP1, MP2, MP3, MP4, MP5, MP6, MP7)) est formé entre les bornes de source (S1, S2) du premier et du deuxième transistor d'entrée PMOS (P1, P2) et la première borne (Uv) de tension d'alimentation pour former la première et la deuxième source (4, 5) de courant continu.

9. Circuit comparateur selon l'une des revendications 4 à 8, **caractérisé en ce qu'**un deuxième miroir de courant (QN1, QN2, QN3, QN4 ; MN1, MN2, MN3, MN4, MN5) est formé entre les bornes de drain (D1, D2) du premier et du deuxième transistor d'entrée PMOS (P1, P2) et la deuxième borne (GND) de tension d'alimentation pour former la troisième et la quatrième source (6, 7) de courant continu.

10. Circuit comparateur selon la revendication 9, **caractérisé en ce que** le premier miroir de courant (MP1, MP2, MP3, MP4, MP5, MP6, MP7) est une cascode.

11. Circuit comparateur selon l'une des revendications 8 à 10, **caractérisé en ce que** les miroirs de courant présentent chacun un transistor de référence (QP1, QN1, MP1, MN1) et au moins deux circuits parallèles constitués de plusieurs (n, n+1) transistors (QP2, QP3 ; QN3, QN4 ; MP4, MP5, MP6, MP7 ; MN4, MN5) et/ou de plusieurs (n, n+1) cellules qui présentent chacune au moins un transistor (QP2, QP3 ; QN3, QN4 ; MP4, MP5, MP6, MP7 ; MN4, MN5) pour former les sources de courant.

12. Circuit comparateur selon la revendication 11, **caractérisé en ce que** la troisième et la quatrième source de courant (6, 7) présentent davantage de transistors ou davantage de cellules que la première et la deuxième source de courant (4, 5), en vue de reprendre le courant qui s'établit en supplément dans les dispositifs (N1, N2) d'établissement de tension.

13. Circuit comparateur selon l'une des revendications 8 à 12, **caractérisé en ce que** pour former la première et la deuxième source de courant (4, 5), le premier miroir de courant est formé de transistors pnp (QP1, QP2, QP3) et **en ce que** pour former la troisième et la quatrième source de courant (6, 7), le deuxième miroir de courant est formé de transistors npn (QN1, QN2, QN3, QN4).

14. Circuit comparateur selon l'une des revendications 8 à 12, **caractérisé en ce que** pour former la première et la deuxième source de courant (4, 5), le premier miroir de courant est formé de transistors PMOS (MP1, MP2, MP3, MP4, MP5, MP6, MP7) et **en ce que** pour former la troisième et la quatrième source de courant (6, 7), le deuxième miroir de courant est formé de transistors NMOS (MN1, MN2, MN3, MN4, MN5).

15. Circuit comparateur selon l'une des revendications précédentes, **caractérisé en ce qu'**un étage d'entrée (9) fait partie d'un comparateur suiveur (2) qui reçoit les deux signaux intermédiaires (Zpos, Zneg) et qui délivre le signal de sortie (OUT).

Fig. 1

Fig. 2a

$U_V$ — QP1 1 cell

$U_V$ — QP2 n cells — $\triangleright$ n·I

$U_V$ — QP3 n cells — $\triangleright$ n·I

II

$\triangleright$ I

IREF

QN1 1 cell

QN2 1 cell

$\triangleright$ (n+1)·I — QN3 n+1 cells

$\triangleright$ (n+1)·I — QN4 n+1 cells

III

Fig. 2b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **CARRILLO J M et al.** Constant-gm Constant-Slew-Rate High-Bandwidth Low-Voltage Rail-to-Rail CMOS Input Stage for VLSI Cell Libraries. *IEEE Journal of Solid-State Circuits,* August 2003, vol. 38 (8, 1), 1364-1372